# EUROPÄISCHE PATENTSCHRIFT

(11) **EP 3 449 571 B1**
(45) Veröffentlichungstag und Bekanntmachung des Hinweises auf die Patenterteilung: **08.09.2021**
(21) Anmeldenummer: 17709671.6
(22) Anmeldetag: 09.03.2017
(51) Int. Cl.: H03K 17/16, H03K 17/082

(54) **VERFAHREN ZUM SCHUTZ EINES HALBLEITERSCHALTERS, SCHUTZVORRICHTUNG FÜR EINEN HALBLEITERSCHALTER UND ANSTEUERSCHALTUNG FÜR EINEN HALBLEITERSCHALTER**
METHOD FOR PROTECTING A SEMICONDUCTOR SWITCH, PROTECTIVE DEVICE FOR A SEMICONDUCTOR SWITCH, AND CONTROL CIRCUIT FOR A SEMICONDUCTOR SWITCH
PROCÉDÉ DE PROTECTION D'UN COMMUTATEUR À SEMI-CONDUCTEUR, DISPOSITIF DE PROTECTION POUR COMMUTATEUR À SEMI-CONDUCTEUR ET CIRCUIT DE COMMANDE D'UN COMMUTATEUR À SEMI-CONDUCTEUR

(30) Priorität: 29.04.2016 DE 102016207384
(43) Veröffentlichungstag der Anmeldung: 06.03.2019
(73) Patentinhaber: Robert Bosch GmbH, 70442 Stuttgart (DE)
(72) Erfinder: RICHTER, Tobias, 74321 Bietigheim-Bissingen (DE); SINN, Peter, 74199 Untergruppenbach (DE); LAICH, Sebastian, 70437 Stuttgart (DE); HEIL, Matthias, 71696 Moeglingen (DE)
(86) Internationale Anmeldenummer: PCT/EP2017/055526
(87) Internationale Veröffentlichungsnummer: WO 2017/186394

(56) Entgegenhaltungen:
- WO-A1-03/085832
- WO-A1-2014/127872
- DE-A1-102010 008 815
- DE-A1-102010 008 815
- US-A1- 2012 200 320
- RUEEDI H ET AL: "SCALE DRIVER FOR HIGH VOLTAGE IGBTS", PCIM. EUROPE. OFFICIAL PROCEEDINGS OF THE INTERNATIONAL POWERCONVERSION CONFERENCE. PROCEEDINGS OF THE EUROPEAN CONFERENCE ONPOWER ELECTRONICS, DRIVES AND MOTION, XX, XX, 22. Juni 1999 (1999-06-22), Seiten 357-363, XP008054677,

## Beschreibung

Die vorliegende Erfindung betrifft eine Schutzvorrichtung für einen Halbleiterschalter und ein Verfahren zum Schutz eines Halbleiterschalters, sowie eine Ansteuerschaltung für einen Halbleiterschalter. Insbesondere betrifft die vorliegende Erfindung den Schutz eines Halbleiterschalters vor Überspannungen.

### Stand der Technik

Beim Betrieb von Halbleiterschaltern, insbesondere von Halbleiterleistungsschaltern, kann es während des Öffnens des Halbleiterschalters unter Last zu einer kurzzeitigen Überhöhung der Spannung über dem Schalter kommen. Derartige Spannungserhöhungen sind beispielsweise aufgrund von induktiven Lasten in einem Lastkreis bzw. einem Kommutierungskreis beim Einsatz von Pulswechselrichtern unvermeidlich.

Um die zulässigen Sperrspannungen eines Halbleiterschalters nicht zu überschreiten, sind daher geeignete Schutzschaltungen erforderlich, welche beispielsweise die Schaltgeschwindigkeit begrenzen und somit durch das Begrenzen der Stromänderung über der Zeit (dl/dt) einer übermäßigen Spannungsüberhöhung über dem Halbleiterschalter entgegenwirken.

Die Druckschrift WO 03/085832 A1 offenbart eine Schaltungsanordnung zum Ansteueren eines Halbleiterschalters mit einer Spannungsbegrenzung. Die Druckschrift RUEEDI H ET AL: "SCALE DRIVER FOR HIGH VOL TAGE IGBTS", PCIM. EUROPE. OFFICIAL PROCEEDINGS OF THE INTERNATIONAL POWERCONVERSION CONFERENCE. PROCEEDINGS OF THE EUROPEAN CONFERENCE ON POWER ELECTRONICS, DRIVES AND MOTION, XX, XX, 22. Juni 1999 (1999-06-22), Seiten 357-363, XP008054677 offenbart eine Treiberschaltung für Hochleistungs-Halbleiterschalter. Die Druckschrift US 2012/200320 A1 offenbart ein Verfahren und eine Vorrichtung zur Ansteuerung von Leistungshalbleiterschaltern. Die Druckschrift WO 2014/127872 A1 offenbart eine Schutzvorrichtung für einen Halbleiterschalter und ein Verfahren zum Betreiben eineer Schutzvorrichtung für einen Halbleiterschalter.

Die Druckschrift DE 10 2010 008 815 A1 offenbart einen Überspannungsschutz für einen Halbleiterschalter. Der Überspannungsschutz wird dabei nur dann aktiviert, wenn der Halbleiterschalter abgeschaltet wird. Im aktiven Zustand des Überspannungsschutzes wird ein Strom durch eine Zener-Diode dazu verwendet, den Halbleiterschalter vorübergehend anzuschalten. Im inaktiven Zustand des Überspannungsschutzes wird der Strom durch die Zener-Diode abgeleitet, ohne Rückwirkung auf den Halbleiterschalter.

### Offenbarung der Erfindung

Die vorliegende Erfindung schafft eine Schutzvorrichtung für einen Halbleiterschalter mit den Merkmalen des Patentanspruchs 1, eine Ansteuerschaltung für einen Halbleiterschalter mit den Merkmalen des Patentanspruchs 6 und ein Verfahren zum Schutz eines Halbleiterschalters mit den Merkmalen des Patentanspruchs 8.

### Demgemäß ist vorgesehen:

Eine Schutzvorrichtung für einen Halbleiterschalter, der von einer Treiberstufe ansteuerbar ist, mit einem Überspannungsdetektor, einem Begrenzungselement, einer Aktivierungsschaltung und einer Kompensationsschaltung. Der Überspannungsdetektor ist mit einem Ausgang des Halbleiterschalters elektrisch gekoppelt. Der Überspannungsdetektor ist dabei dazu ausgelegt, ein Überspannungssignal bereitzustellen, wenn eine elektrische Spannung am Ausgang des Halbleiterschalters einen vorbestimmten Schwellwert überschreitet. Das Begrenzungselement ist dazu ausgelegt, das von dem Überspannungsdetektor bereitgestellte Überspannungssignal auf eine vorbestimmte Zeitdauer zu begrenzen. Das zeitlich begrenzte Überspannungssignal wird an einem Ausgangsanschluss des Begrenzungselements bereitgestellt. Die Aktivierungsschaltung ist dazu ausgelegt, eine elektrische Verbindung zwischen dem Überspannungsdetektor und dem Begrenzungselement freizugeben, wenn an einem Eingang der Treiberstufe für den Halbleiterschalter ein vorbestimmtes Ansteuersignal anliegt. Hierzu kann die Aktivierungsschaltung dazu ausgelegt sein, das vorbestimmte Ansteuersignal am Eingang der Treiberstufe zu detektieren. Die Kompensationsschaltung ist mit dem Ausgangsanschluss des Begrenzungselements elektrisch gekoppelt. Die Kompensationsschaltung ist dazu ausgelegt, in Abhängigkeit von dem durch das Begrenzungselement zeitlich begrenzten Überspannungssignal an einem Eingang der Treiberstufe für den Halbleiterschalter ein Kompensationssignal bereitzustellen.

### Weiterhin ist vorgesehen:

Eine Ansteuerschaltung für einen Halbleiterschalter mit einer Treiberstufe und einer erfindungsgemäßen Schutzvorrichtung für den Halbleiterschalter. Die Treiberstufe umfasst mindestens einen Ausgangsanschluss und mindestens einen Eingangsanschluss. Die Treiberstufe ist dazu ausgelegt, in Abhängigkeit von einem an dem Eingangsanschluss bereitgestellten Eingangssignal an dem Ausgangsanschluss der Treiberstufe ein Ansteuersignal für den Halbleiterschalter bereitzustellen.

### Ferner ist vorgesehen:

Ein Verfahren zum Schutz eines Halbleiterschalters, der von einer Treiberstufe ansteuerbar ist. Das Verfahren umfasst einen Schritt zum Bereitstellen eines Überspannungssignals, wenn an einem Anschluss des Halbleiterschalters eine vorbestimmte Spannung überschritten wird. Das Verfahren umfasst weiterhin einen Schritt zum Detektieren eines vorbestimmten Ansteuersignals am Eingang der Treiberstufe und einen Schritt zum Freigeben des Überspannungssignals, wenn an dem Eingang der Treiberstufe das vorbestimmte Ansteuersignal detektiert wird. Ferner umfasst das Verfahren einen Schritt zum Begrenzen des freigegebenen Überspannungssignals auf eine maximale Zeitdauer und einen Schritt zum Bereitstellen eines Kompensationssignals an einem Eingangsanschluss der Treiberstufe für den Halbleiterschalter in Abhängigkeit von dem zeitlich begrenzten Überspannungssignal.

### Vorteile der Erfindung

Der vorliegenden Erfindung liegt die Erkenntnis zugrunde, dass bei einem schnellen Abschalten von Lasten, insbesondere von induktiven Lasten, es zu Spannungsüberhöhungen an dem jeweiligen Schaltelement kommen kann, die gegebenenfalls zu Beeinträchtigungen bis hin zur Zerstörung des Schaltelements führen können. Daher müssen gegebenenfalls zum Schutz solcher Schaltelemente geeignete Schutzschaltungen vorgesehen sein, die beim Überschreiten einer maximal zulässigen Spannung in das Schaltverhalten eingreifen. Damit ein Schalter anschließend jedoch wieder vollständig geöffnet werden kann, muss eine statische Betriebsspannung, die nach Beendigung des Schaltvorgangs bei geöffnetem Schalter anliegt, kleiner sein als die Eingriffsschwelle der Schutzschaltung.

Es ist daher eine Idee der vorliegenden Erfindung, dieser Erkenntnis Rechnung zu tragen und einen erweiterten Schutz für einen Halbleiterschalter vorzusehen. Insbesondere besteht der Kern der vorliegenden Erfindung darin, für ein Ansprechen des Überspannungsschutzes mehrere Rahmenbedingungen miteinander zu kombinieren. So wird ein Ansprechen des Überspannungsschutzes mittels eines Gegenkopplungszweiges nur dann aktiviert, wenn tatsächlich ein Ausschaltvorgang aktiviert ist, das heißt an einer Treiberstufe ein entsprechendes Ausschaltsignal anliegt, die Spannung über dem zu schützenden Halbleiterschalter größer ist als eine Eingriffsschwelle und darüber hinaus auch eine zusätzliche Zeitbegrenzung des Eingriffs noch nicht abgelaufen ist. Nur wenn alle diese Bedingungen zutreffen, erfolgt ein Eingriff des Überspannungsschutzes. Hierbei wird an der Treiberstufe für den zu schützenden Halbleiterschalter ein Kompensationssignal bereitgestellt, um den zu schützenden Halbleiterschalter zumindest teilweise anzusteuern und somit die Stromänderung während des Ausschaltvorgangs zu begrenzen. Auf diese Weise ist es in den meisten Fällen möglich, den Spannungsabfall über dem zu schützenden Halbleiterschalter zu begrenzen und somit bis zum Ende des Ausschaltvorgangs auf einem nahezu konstanten Niveau zu halten.

Die Stromänderung über der Zeit ergibt sich dabei in der Regel automatisch so, dass der zulässige Sperrspannungsbereich des zu schützenden Halbleiterschalters optimal ausgenutzt wird. In der Regel ist dabei eine nahezu konstante Stromänderung pro Zeiteinheit erreichbar.

Der Eingriff des Überspannungsschutzes erfolgt dabei auf der Eingangsseite der Treiberstufe. Auf diese Weise ist keine direkte Einspeisung von Kompensationsspannungen an den Steueranschluss des Halbleiterschalters erforderlich. Dadurch können treiberinterne Querströme vermieden werden. Dies führt zu einer geringeren Belastung der Treiberendstufe während des Eingriffs.

Gemäß einer Ausführungsform umfasst der Überspannungsdetektor eine Avalanche-Diode oder eine Zener-Diode. Insbesondere kann der Überspannungsdetektor eine Serienschaltung aus einer konventionellen Halbleiterdiode und einer Avalanche-Diode oder Zener-Diode mit entgegengesetzten Durchlassrichtungen umfassen. Hierdurch kann auf einfache und zuverlässige Weise ein Überspannungssignal zum Schutz des Halbleiterschalters bereitgestellt werden.

Gemäß einer Ausführungsform umfasst das Begrenzungselement einen Hochpass-Filter. Insbesondere kann das Begrenzungselement ein R-C-Glied umfassen. Dabei kann die Kapazität des R-C-Glieds bzw. des Hochpass-Filters im Signalpfad des Überspannungssignals angeordnet sein. Auf diese Weise kann eine einfache und zuverlässige zeitliche Begrenzung des Überspannungssignals realisiert werden.

Gemäß der Erfindung ist die Aktivierungsschaltung dazu ausgelegt, die elektrische Verbindung zwischen dem Überspannungsdetektor und dem Begrenzungselement in Abhängigkeit von einem Vergleich von Spannungswerten zwischen einem Eingangssignal der Treiberstufe und einem Ausgangssignal der Treiberstufe freizugeben. Insbesondere kann die Aktivierungsschaltung das Überspannungssignal dann freigeben, wenn am Eingang der Treiberstufe ein Ansteuersignal für ein Ausschalten des zu schützenden Halbleiterschalters anliegt. Auf diese Weise kann eine Anforderung für ein Ausschalten des zu schützenden Halbleiterschalters detektiert werden, und das Ansprechen der Schutzvorrichtung kann auf ein derartiges Ausschalten des Halbleiterschalters begrenzt werden.

Gemäß einer Ausführungsform der Ansteuerschaltung für den Halbleiterschalter umfasst die Treiberstufe der Ansteuerschaltung mindestens zwei Transistoren, die jeweils mit einem Anschluss mit dem Ausgangsanschluss der Treiberstufe elektrisch gekoppelt sind.

Gemäß einer Ausführungsform umfasst die Schutzvorrichtung eine Diode, die zwischen dem Ausgangsanschluss der Kompensationsschaltung (und dem Steueranschluss des Halbleiterschalters angeordnet ist. Insbesondere kann die Diode hierbei antiparallel zwischen einen Steueranschluss und einem Ausgangsanschuss eines Transistors einer Treiberstufe für den Halbleiterschalter angeordnet werden. Hierdurch kann ein besonders schnelles Ansprechen der Schutzvorrichtung für den Halbleiterschalter erreicht werden.

Gemäß einer Ausführungsform des Verfahrens zum Schutz eines Halbleiterschalters gibt der Schritt zum Freigeben des Überspannungssignals das Überspannungssignal dann frei, wenn an dem Eingang der Treiberstufe ein Ansteuersignal zum Schließen des Halbleiterschalters anliegt. Ferner stellt der Schritt zum Bereitstellen des Kompensationssignals am Eingang der Treiberstufe ein Kompensationssignal bereit, das dazu ausgelegt ist, den Halbleiterschalter zumindest teilweise anzusteuern. Auf diese Weise kann durch die Ansteuerung des Halbleiterschalters mit dem Kompensationssignal ein zu rasches Öffnen des Halbleiterschalters hinausgezögert werden, um eine maximale Stromänderung durch den Halbleiterschalter zu begrenzen und somit einem gefährlichen Spannungsanstieg über dem Halbleiterschalter entgegenwirken.

### Kurze Beschreibung der Zeichnungen

Die vorliegende Erfindung wird nachfolgend anhand der in den schematischen Figuren der Zeichnungen angegebenen Ausführungsbeispiele näher erläutert. Dabei zeigen:
- Figur 1:: eine schematische Darstellung einer Ansteuervorrichtung für einen Halbleiterschalter mit einer Schutzvorrichtung gemäß einer nicht zur Erfindung gehörenden, beispielhaften Ausführungsform;
- Figur 2:: eine schematische Darstellung einer Ansteuerung für einen Halbleiterschalter mit einem detaillierten Schaltungsbeispiel für eine Schutzvorrichtung gemäß einer erfindungsgemäßen Ausführungsform; und
- Figur 3:: eine schematische Darstellung eines Ablaufdiagramms, wie es einem Verfahren zum Schutz eines Halbleiterschalters gemäß einer Ausführungsform zugrunde liegt.

### Ausführungsformen

In allen Figuren sind gleiche bzw. funktionsgleiche Elemente und Vorrichtungen, soweit nicht anders angegeben, mit gleichen Bezugszeichen versehen.

Halbleiterschalter im Sinne der vorliegenden Erfindung sind dabei grundsätzlich alle Arten von Schaltelementen, bei denen auf Basis einer Halbleiterstruktur eine elektrische Verbindung geschlossen oder geöffnet werden kann. Das Öffnen und Schließen des Halbleiterschalters erfolgt dabei durch Ansteuerung des Halbleiterschalters mittels eines elektrischen Signals. Halbleiterschalter können beispielsweise MOSFET oder bipolare Transistoren mit einem isolierten Gateanschluss (IGBT) umfassen. Darüber hinaus ist die erfindungsgemäße Schutzvorrichtung auch auf alle anderen Arten von Halbleiterschaltern anwendbar.

Auch wenn die nachfolgend noch näher beschriebene Schutzvorrichtung im Zusammenhang mit Halbleiterschaltern beschrieben wird, so ist sie darüber hinaus ebenso auf andere Schaltelemente anwendbar, bei denen ein Schutz vor Überspannung beim Schließen des Schaltelements erreicht werden soll.

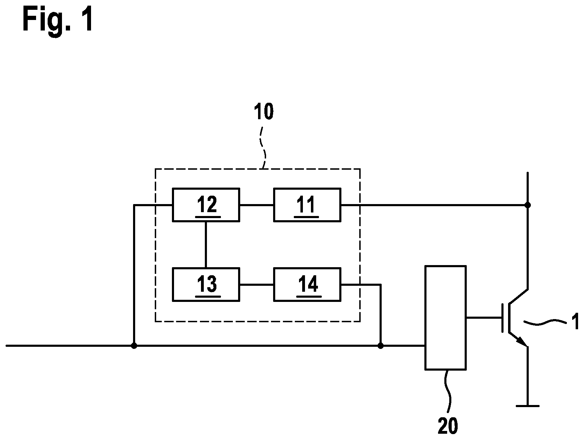

Figur 1 zeigt eine schematische Darstellung einer Ansteuerschaltung für einen Halbleiterschalter 1 gemäß einer nicht zur Erfindung gehörenden, beispielhaften Ausführungsform. Der zu schützende Halbleiterschalter 1 umfasst neben einem Eingangsanschluss und einem Ausgangsanschluss einen Steueranschluss. Dieser Steueranschluss ist elektrisch mit einer Treiberstufe 20 gekoppelt. Die Treiberstufe 20 stellt dabei am Steueranschluss des Halbleiterschalters 1 ein elektrisches Signal bereit, welches zum Ansteuern des Halbleiterschalters 1 geeignet ist. Zur Ansteuerung des Halbleiterschalters 1 kann an einem oder an mehreren Eingangsanschlüssen der Treiberstufe 20 ein Eingangssignal bereitgestellt werden. Basierend auf diesem Eingangssignal erzeugt die Treiberstufe 20 ein Ausgangssignal, welches dazu geeignet ist, den Halbleiterschalter 1 entsprechend anzusteuern. Bei dem Eingangssignal, welches an der Treiberstufe 20 bereitgestellt werden kann, kann es sich beispielsweise um ein digitales Signal handeln, wobei bei einem ersten Wert dieses Eingangssignals der Halbleiterschalter 1 geöffnet wird und bei einem zweiten Wert des Eingangssignals der Halbleiterschalter 1 geschlossen wird. Alternativ ist es auch denkbar, dass die Treiberstufe 20 mehrere Eingangsanschlüsse umfasst. In diesem Fall kann beispielsweise beim Anlegen eines Steuersignals an einem ersten Eingangsanschluss der Treiberstufe 20 der Halbleiterschalter 1 geschlossen werden. Wird dagegen an einem weiteren Eingangsanschluss der Treiberstufe 20 ein geeignetes Eingangssignal angelegt, so kann die Treiberstufe 20 ein Ausgangssignal an dem Steueranschluss des Halbleiterschalters 1 anlegen, um den Halbleiterschalter 1 zu öffnen. Darüber hinaus sind auch beliebige weitere Konfigurationen zum Ansteuern des Halbleiterschalters 1 mittels der Treiberstufe 20 denkbar.

Ist der Halbleiterschalter 1 beispielsweise geschlossen, so kann durch den Halbleiterschalter 1 und eine an dem Halbleiterschalter 1 angeschlossene Last (hier nicht dargestellt) ein elektrischer Strom fließen. Wird daraufhin der Halbleiterschalter 1 geöffnet, so kann bei einer entsprechenden Last gegebenenfalls zwischen dem Eingangsanschluss und dem Ausgangsanschluss des Halbleiterschalters 1 aufgrund der raschen Stromabsenkung durch den Halbleiterschalter 1 eine Spannungsüberhöhung hervorgerufen werden. Ohne weitere Schutzmaßnahmen kann diese Spannungserhöhung gegebenenfalls zu einer Beschädigung des Halbleiterschalters 1 führen.

Zur Vermeidung derartiger Spannungsüberhöhungen ist eine Schutzvorrichtung 10 vorgesehen. Die Schutzvorrichtung 10 umfasst einen Überspannungsdetektor 11, eine Aktivierungsschaltung 12, ein Begrenzungselement 13 und eine Kompensationsschaltung 14. Der Überspannungsdetektor 11 ist mit einem Anschluss elektrisch mit dem Ausgang des Halbleiterschalters 1 verbunden. Ein weiterer Anschluss des Überspannungsdetektors 11 ist mit der Aktivierungsschaltung 12 elektrisch verbunden. Die Aktivierungsschaltung 12 ist weiterhin elektrisch mit dem Begrenzungselement 13 verbunden. Weiterhin ist das Begrenzungselement 13 mit der Kompensationsschaltung 14 verbunden. Die Kompensationsschaltung 14 ist darüber hinaus mit mindestens einem Eingangsanschluss der Treiberstufe 20 elektrisch verbunden. Ferner kann die Aktivierungsschaltung 12 mit mindestens einem Eingangsanschluss der Treiberstufe 20 verbunden sein. Gegebenenfalls kann die Aktivierungsschaltung 12 auch mit mindestens einem Ausgangsanschluss der Treiberstufe 20 verbunden sein.

Überschreitet die elektrische Spannung an dem Ausgang des Halbleiterschalters 1, der mit dem Überspannungsdetektor verbunden ist, einen vorgegebenen Schwellwert, so stellt der Überspannungsdetektor 11 an dem mit der Aktivierungsschaltung 12 verbundenen Ausgang ein Überspannungssignal bereit.

Die Aktivierungsschaltung 12 überwacht das Eingangssignal bzw. die Eingangssignale, die an dem Eingangsanschluss bzw. den Eingangsanschlüssen der Treiberstufe 20 anliegen. Erkennt die Aktivierungsschaltung 12 dabei, dass entsprechend dem oder den Eingangssignalen an der Treiberstufe 20 der Halbleiterschalter 1 geöffnet werden soll, so gibt die Aktivierungsschaltung 12 das von dem Überspannungsdetektor 11 bereitgestellte Überspannungssignal frei, so dass das von dem Überspannungsdetektor 11 bereitgestellte Überspannungssignal an dem Anschluss des Begrenzungselements 13 anliegt, der mit der Aktivierungsschaltung 12 verbunden ist. Mit anderen Worten, das Überspannungssignal des Überspannungsdetektors 11 wird nur dann an dem Begrenzungselement 13 bereitgestellt, wenn die Aktivierungsschaltung 12 an dem Eingang in der Treiberstufe 20 ein Steuersignal detektiert, das ein Öffnen des Halbleiterschalters 1 veranlassen soll.

Das Begrenzungselement 13 leitet daraufhin das freigegebene Überspannungssignal zunächst an die Kompensationsschaltung 14 weiter. Die Weitergabe des Überspannungssignals wird dabei jedoch auf eine vorbestimmte Zeitdauer begrenzt. Nach Ablauf dieser vorbestimmten Zeitdauer unterbindet das Begrenzungselement 13 die Weiterleitung des Überspannungssignals an die Kompensationsschaltung 14.

Solange die Kompensationsschaltung 14 von dem Begrenzungselement 13 ein Überspannungssignal empfängt, gibt die Kompensationsschaltung 14 daraufhin ein Kompensationssignal aus. Dieses Kompensationssignal kann an einem oder an mehreren Eingängen der Treiberstufe 20 bereitgestellt werden. Dieses Kompensationssignal ist dabei derart ausgestaltet, dass die Treiberstufe 20 durch dieses Kompensationssignal veranlasst wird, an dem Steueranschluss des Halbleiterschalters 1 ein Ansteuersignal bereitzustellen, welches den Halbleiterschalter 1 zumindest teilweise ansteuert, also in einen zumindest teilweise leitenden Zustand versetzt.

Das von der Kompensationsschaltung 14 am Eingang der Treiberstufe 20 bereitgestellte Kompensationssignal führt somit dazu, dass der Halbleiterschalter 1 nicht in einen vollständig geöffneten Zustand übergeht, sondern noch weiterhin ein begrenzter Stromfluss durch den Halbleiterschalter 1 ermöglicht wird. Somit reduziert sich die Stromänderung pro Zeit (dl/dt). Folglich verringert sich auch die Spannungsüberhöhung, die gegebenenfalls durch eine am Halbleiterschalter 1 angeschlossene induktive Last hervorgerufen wird.

Die Ansteuerung des Halbleiterschalters 1 über die Treiberstufe 20 infolge des von der Kompensationsschaltung 14 ausgegebenen Kompensationssignals erfolgt dabei jedoch nur, solange die Aktivierungsschaltung 12 ein Eingangssignal der Treiberstufe 20 detektiert, welches ein Öffnen des Halbleiterschalters 1 veranlasst. Darüber hinaus wird durch das Begrenzungselement 13 auch die Weiterleitung des Überspannungssignals von dem Überspannungsdetektor 12 zeitlich begrenzt. Nach Ablauf der zeitlichen Begrenzung durch das Begrenzungselement 13 und/oder den Wegfall der Freigabebedingung für die Aktivierungsschaltung 12 wird durch die Kompensationsschaltung 14 kein weiteres Kompensationssignal bereitgestellt.

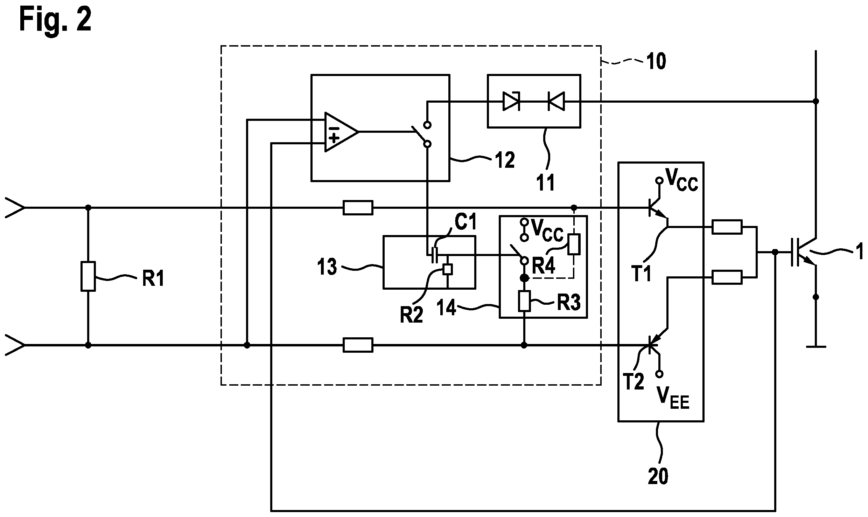

Figur 2 zeigt eine schematische Darstellung eines Beispiels für eine Ansteuerschaltung eines Halbleiterschalters 1 mit einer Schutzvorrichtung 10 gemäß einem erfindungsgemäßen Ausführungsbeispiel.

Die Treiberstufe 20 umfasst in diesem Ausführungsbeispiel zwei Eingangsanschlüsse E1 und E2. Gegebenenfalls können diese beiden Eingangsanschlüsse über einen geeignet dimensionierten elektrischen Widerstand R1 miteinander verbunden sein. Wird beispielsweise an den Eingangsanschlüssen der Treiberstufe 20 eine positive Spannung, beispielsweise in Höhe einer Gatetreiberversorgungsspannung Vcc angelegt, so wird hierauf am Steueranschluss des Halbleiterschalters 1 durch die Treiberstufe 20 ein Treibersignal bereitgestellt, welches den Halbleiterschalter 1 in einen elektrisch leitenden Zustand versetzt. Wird dagegen an den Eingängen der Treiberstufe 20 eine negative Spannung, beispielsweise in Höhe der negativen Gatetreiberversorgungsspannung V_{EE} bereitgestellt, so erzeugt die Treiberstufe 20 ein Steuersignal, welches den Halbleiterschalter in einen elektrisch nicht leitfähigen Zustand versetzt.

Die Treiberstufe 20 kann beispielsweise zwei Transistoren T1 und T2 umfassen, wobei jeweils ein Steueranschluss eines Transformators mit einem Eingangsanschluss der Treiberstufe 20 elektrisch gekoppelt ist. Beim Ansteuern eines ersten Transistors T1 kann beispielsweise die positive Gatetreiberversorgungsspannung Vcc an den Steueranschluss des Halbleiterschalters 1 durchgeschaltet werden. Beim Ansteuern des zweiten Transistors T2 kann alternativ die negative Gatetreiberversorgungsspannung V_{EE} an den Steueranschluss des Halbleiterschalters 1 durchgeschaltet werden.

Die Aktivierungsschaltung 12 vergleicht ein Treibersignal am Ausgang der Treiberstufe 20 mit einem Steuersignal an einem Eingang der Treiberstufe 20. Ergibt sich bei der Auswertung dieser Signale, insbesondere bei der Auswertung des Eingangssignals der Treiberstufe 20, dass der Halbleiterschalter 1 geöffnet werden soll, so kann die Aktivierungsschaltung 12 eine elektrische Verbindung zwischen dem Überspannungsdetektor 11 und dem Begrenzungselement 13 schließen. Hierzu ist jedes beliebige elektrische Schaltelement S1 geeignet. Insbesondere kann die elektrische Verbindung beispielsweise mittels eines geeigneten Transistors oder einem anderen Halbleiterschaltelement realisiert werden. Bei dem Überspannungsdetektor 11 zwischen dem Ausgang des Halbleiterschalters 1 und der Aktivierungsschaltung 12 kann es sich beispielsweise um eine Avalanche-Diode oder eine Zener-Diode handeln. Insbesondere kann der Überspannungsdetektor 11 auch durch eine Serienschaltung einer Avalanche-Diode oder einer Zener-Diode mit einer mit entgegengesetzter Durchlassrichtung angeordneten konventionellen Diode realisiert werden. Grundsätzlich sind jedoch auch weitere Schaltungsanordnungen zur Detektion einer Überspannung am Ausgang des Halbleiterschalters 1 möglich.

Das Begrenzungselement 13 dient zu einer zeitlichen Begrenzung eines durch die Aktivierungsschaltung 12 freigegebenen Überspannungssignals von dem Überspannungsdetektor 11. Hierzu kann das Begrenzungselement 13 beispielsweise in Form eines Hochpass-Filters ausgeführt sein. Insbesondere kann das Begrenzungselement 13 in Form eines R-C-Glieds aus dem Kondensator C1 und dem Widerstand R2 realisiert werden.

Basierend auf dem so zeitlich begrenzten Überspannungssignal kann in der Kompensationsschaltung 14 ein Kompensationssignal erzeugt werden. Beispielsweise kann hierzu durch Ansteuern eines Schaltelements S2 in der Kompensationsschaltung 14 die positive Gatetreiberversorgungsspannung Vcc über einen Widerstand R3 an mindestens einem Eingangsanschluss der Treiberstufe 20 angelegt werden. Wie in Figur 2 dargestellt, kann insbesondere der untere Transistor T2, welcher mit der negativen Gatetreiberversorgungsspannung V_{EE} gekoppelt ist, dabei mit dem Kompensationssignal der Kompensationsschaltung 14 angesteuert werden. Optional kann das Kompensationssignal über einen weiteren Widerstand R4 auch an einem weiteren Eingangsanschluss der Treiberstufe 20 bereitgestellt werden, um zum Beispiel auch den oberen Transistor T1, der mit der positiven Gatetreiberversorgungsspannung Vcc verbunden ist, anzusteuern.

Weiterhin kann optional zwischen den Basisanschluss des unteren Transistors T2 und den Emitteranschluss des unteren Transistors T2 eine Diode (hier nicht dargestellt) vorgesehen sein. Hierbei ist die Anode der Diode mit dem Emitteranschluss des Transistors T2 verbunden. Dieser Emitteranschluss des Transistors T2 ist weiter über einen Widerstand mit dem Steueranschluss des Halbleiterschalters 1 verbunden. Die Kathode der Diode ist mit dem Basisanschluss des Transistors T2 verbunden. Dieser Basisanschluss des Transistors ist mit dem Widerstand R3 der Kompensationsschaltung 14 verbunden. Eine derartige Diode ermögliche ein besonders rasches Ansprechen des Überspannungsschutzes für den Halbleiterschalter 1.

Durch das Kompensationssignal, das in dem hier beschriebenen Fall aus einer positiven Spannung, wie zum Beispiel der positiven Gatetreiberversorgungsspannung V_{CC}, erzeigt wird, die über einen oder mehrere Widerstände an dem oder den Eingängen der Treiberstufe 20 bereitgestellt wird, kann einem sofortigen Öffnen des Halbleiterschalters 1 entgegengewirkt werden, so dass zeitlich begrenzt weiterhin ein begrenzter Stromfluss durch den Halbleiterschalter 1 aufrechterhalten wird.

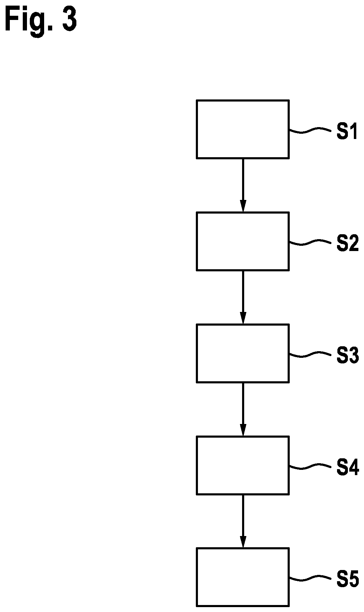

Figur 3 zeigt eine schematische Darstellung eines Ablaufdiagramms, wie es einem Verfahren zum Schutz eines Halbleiterschalters gemäß einer Ausführungsform zugrunde liegt.

In Schritt S1 wird ein Überspannungssignal bereitgestellt, wenn an einem Anschluss des Halbleiterschalters 1 eine vorbestimmte Spannung überschritten wird. In Schritt S2 wird ein vorbestimmtes Ansteuersignal am Eingang einer Treiberstufe 20 für den Halbleiterschalter 1 detektiert. Wird ein solches vorbestimmtes Ansteuersignal, insbesondere Ansteuersignal zum Öffnen des Halbleiterschalters am Eingang in der Treiberstufe 20 detektiert, so wird das bereitgestellte Überspannungssignal in Abhängigkeit von einem Vergleich von Spannungswerten zwischen einem Eingangssignal der Treiberstufe 20 und einem Ausgangssignal der Treiberstufe 20 freigegeben.

Dieses freigegebene Überspannungssignal wird in Schritt S4 auf eine vorbestimmte maximale Zeitdauer begrenzt. Schließlich wird in Schritt S5 ein Kompensationssignal an einem Eingangsanschluss der Treiberstufe 20 für den Halbleiterschalter 1 bereitgestellt. Das Bereitstellen des Kompensationssignals erfolgt dabei in Abhängigkeit von dem zeitlich begrenzten Überspannungssignal. Das bereitgestellte Kompensationssignal am Eingang der Treiberstufe 20 ist dabei insbesondere derart ausgelegt, dass hierdurch die Treiberstufe 20 den Halbleiterschalter 1 zumindest teilweise ansteuert.

Zusammenfassend betrifft die vorliegende Erfindung einen Schutz eines Halbleiterschalters vor Überspannungen während eines Ausschaltvorgangs. Hierbei wird an einem Eingang einer Treiberstufe für einen auszuschaltenden Halbleiterschalter ein Kompensationssignal bereitgestellt, wenn die Spannung am Ausgang des Halbleiterschalters einen vorgegebenen Grenzwert überschreitet, und dabei gleichzeitig eine Anforderung für ein Öffnen des Halbleiterschalters an einem Eingang der Treiberstufe für den Halbleiterschalter detektiert wird. Dieses Kompensationssignal wird dabei auf eine vorgegebene Zeitspanne begrenzt. Basierend auf dem so bereitgestellten Kompensationssignal steuert die Treiberstufe für den Halbleiterschalter den Halbleiterschalter teilweise an, um ein übermäßig schnelles Öffnen des Halbleiterschalters zu unterbinden.

## Patentansprüche

1. Schutzvorrichtung für einen Halbleiterschalter (1), der von einer Treiberstufe (20) ansteuerbar ist, mit:
einem Überspannungsdetektor (11), der mit einem Ausgang des Halbleiterschalter (1) elektrisch gekoppelt ist, und der dazu ausgelegt ist, ein Überspannungssignal bereitzustellen, wenn eine elektrische Spannung an dem Ausgang des Halbleiterschalters (1) einen vorbestimmten Schwellwert überschreitet;
einem Begrenzungselement (13), das dazu ausgelegt ist, das von dem Überspannungsdetektor (11) bereitgestellte Überspannungssignal auf eine vorbestimmte Zeitdauer zu begrenzen und das zeitlich begrenzte Überspannungssignal an einem Ausgangsanschluss des Begrenzungselements (13) bereitzustellen;
einer Aktivierungsschaltung (12), die dazu ausgelegt ist, eine elektrische Verbindung zwischen dem Überspannungsdetektor (11) und dem Begrenzungselement (13) freizugeben, wenn an einem Eingang der Treiberstufe (20) für den Halbleiterschalter (1) ein vorbestimmtes Ansteuersignal anliegt; und
einer Kompensationsschaltung (14), die mit dem Ausgangsanschluss des Begrenzungselements (13) elektrisch gekoppelt ist und die dazu ausgelegt ist, in Abhängigkeit von dem durch das Begrenzungselement (13) zeitlich begrenzten Überspannungssignal an einem Eingang der Treiberstufe (20) für den Halbleiterschalter (1) ein Kompensationssignal bereitzustellen,
**dadurch gekennzeichnet, dass** die Aktivierungsschaltung (12) dazu ausgelegt ist, die elektrische Verbindung zwischen dem Überspannungsdetektor (11) und dem Begrenzungselement (13) in Abhängigkeit von einem Vergleich von Spannungswerten zwischen einem Eingangssignal der Treiberstufe (20) und einem Ausgangssignal der Treiberstufe (20) freizugeben.

2. Schutzvorrichtung nach Anspruch 1, wobei der Überspannungsdetektor (11) eine Avalanche-Diode oder eine Zener-Diode umfasst.

3. Schutzvorrichtung nach Anspruch 1 oder 2, wobei das Begrenzungselement (13) einen Hochpass-Filter umfasst.

4. Schutzvorrichtung nach einem der Ansprüche 1 bis 3, wobei das Begrenzungselement (13) ein R-C-Glied umfasst.

5. Schutzvorrichtung nach einem der Ansprüche 1 bis 4, mit einer Diode, die zwischen dem Ausgangsanschluss der Kompensationsschaltung (14) und dem Steueranschluss des Halbleiterschalters (1) angeordnet ist.

6. Ansteuerschaltung für einen Halbleiterschalter (1), mit:
einer Treiberstufe (20), mit einem Ausgangsanschluss und mindestens einem Eingangsanschluss, die dazu ausgelegt ist, in Abhängigkeit von einem an dem Eingangsanschluss bereitgestellten Eingangssignal an dem Ausgangsanschluss ein Ansteuersignal für den Halbleiterschalter (1) bereitzustellen; und
einer Schutzvorrichtung für den Halbleiterschalter (1) gemäß einem der Ansprüche 1 bis 5.

7. Ansteuerschaltung nach Anspruch 6, wobei die Treiberstufe (20) mindestens zwei Transistoren (T1, T2) umfasst, die jeweils mit einem Anschluss mit dem Ausgangsanschluss der Treiberstufe (20) elektrisch gekoppelt sind.

8. Verfahren zum Schutz eines Halbleiterschalters (1), der von einer Treiberstufe (20) ansteuerbar ist, mit den Schritten:
Bereitstellen (S1) eines Überspannungssignals durch einen Überspannungsdetektor (11), wenn an einem Anschluss des Halbleiterschalters (1) eine vorbestimmte Spannung überschritten wird;
Detektieren (S2) eines vorbestimmten Ansteuersignals an einem Eingang der Treiberstufe (20);
Freigeben (S3) des Überspannungssignals durch eine Aktivierungsschaltung (12), die dazu ausgelegt ist, eine elektrische Verbindung zwischen dem Überspannungsdetektor (11) und einem Begrenzungselement (13) freizugeben, wenn an einem Eingang der Treiberstufe (20) das vorbestimmte Ansteuersignal detektiert wird;
Begrenzen (S4) des freigegebenen Überspannungssignals auf eine maximale Zeitdauer durch das Begrenzungselement (13);
Bereitstellen (S5) eines Kompensationssignals an dem Eingangsanschluss der Treiberstufe (20) für den Halbleiterschalter (1), in Abhängigkeit des zeitlich begrenzten Überspannungssignals
**dadurch gekennzeichnet, dass** die Aktivierungsschaltung (12) dazu ausgelegt ist, eine elektrische Verbindung zwischen dem Überspannungsdetektor (11) und dem Begrenzungselement (13) in Abhängigkeit von einem Vergleich von Spannungswerten zwischen einem Eingangssignal der Treiberstufe (20) und einem Ausgangssignal der Treiberstufe (20) freizugeben.

9. Verfahren nach Anspruch 8, wobei der Schritt (S3) zum Freigeben des Überspannungssignals das Überspannungssignal freigibt, wenn an dem Eingang der Treiberstufe (20) ein Ansteuersignal zum Öffnen des Halbleiterschalters (1) anliegt; und
der Schritt (S5) zum Bereitstellen des Kompensationssignals an dem Eingang der Treiberstufe (20) ein Kompensationssignal bereitstellt, das dazu ausgelegt ist, den Halbleiterschalter (1) zumindest teilweise anzusteuern.

## Claims

1. Protective device for a semiconductor switch (1), which can be controlled by a driver stage (20), having:
an overvoltage detector (11), which is electrically coupled to an output of the semiconductor switch (1), and which is designed to provide an overvoltage signal when an electrical voltage at the output of the semiconductor switch (1) exceeds a predetermined threshold value;
a limiting element (13), which is designed to limit the overvoltage signal supplied by the overvoltage detector (11) to a predetermined duration and to provide the temporally limited overvoltage signal at an output terminal of the limiting element (13);
an activation circuit (12), which is designed to enable an electrical connection between the overvoltage detector (11) and the limiting element (13) if a predetermined control signal is present at an input of the driver stage (20) for the semiconductor switch (1); and
a compensation circuit (14), which is electrically coupled to the output terminal of the limiting element (13) and which is designed to provide a compensation signal at an input of the driver stage (20) for the semiconductor switch (1) as a function of the overvoltage signal that is temporally limited by the limiting element (13),
**characterized in that** the activation circuit (12) is designed to enable the electrical connection between the overvoltage detector (11) and the limiting element (13), as a function of a comparison of voltage values between an input signal of the driver stage (20) and an output signal of the driver stage (20).

2. Protective device according to Claim 1, wherein the overvoltage detector (11) comprises an avalanche diode or a Zener diode.

3. Protective device according to Claim 1 or 2, wherein the limiting element (13) comprises a high-pass filter.

4. Protective device according to any one of Claims 1 to 3, wherein the limiting element (13) comprises an R-C element.

5. Protective device according to any one of Claims 1 to 4, having a diode, which is arranged between the output terminal of the compensation circuit (14) and the control terminal of the semiconductor switch (1).

6. Activation circuit for a semiconductor switch (1), having:
a driver stage (20), with an output terminal and at least one input terminal, which is designed to provide a control signal for the semiconductor switch (1) at the output terminal as a function of an input signal provided at the input terminal; and
a protective device for the semiconductor switch (1) according to any one of Claims 1 to 5.

7. Activation circuit according to Claim 6, wherein the driver stage (20) comprises at least two transistors (T1, T2), each of which is electrically coupled with one terminal to the output terminal of the driver stage (20).

8. Method for protecting a semiconductor switch (1), which can be controlled by a driver stage (20), having the steps:
providing (S1) an overvoltage signal by way of an overvoltage detector (11) if a predetermined voltage is exceeded at a terminal of the semiconductor switch (1);
detecting (S2) a predetermined control signal at an input of the driver stage (20);
enabling (S3) the overvoltage signal by way of an activation circuit (12), which is designed to enable an electrical connection between the overvoltage detector (11) and a limiting element (13) if the predetermined control signal is detected at an input of the driver stage (20);
limiting (S4) the enabled overvoltage signal to a maximum duration by way of the limiting element (13);
providing (S5) a compensation signal at the input terminal of the driver stage (20) for the semiconductor switch (1), as a function of the temporally limited overvoltage signal,
**characterized in that** the activation circuit (12) is designed to enable an electrical connection between the overvoltage detector (11) and the limiting element (13), as a function of a comparison of voltage values between an input signal of the driver stage (20) and an output signal of the driver stage (20).

9. Method according to Claim 8, wherein the step (S3) for enabling the overvoltage signal enables the overvoltage signal when a control signal to open the semiconductor switch (1) is present at the input of the driver stage (20); and
the step (S5) for providing the compensation signal at the input of the driver stage (20) provides a compensation signal, which is designed to control the semiconductor switch (1), at least in part.

## Revendications

1. Dispositif de protection pour un commutateur à semi-conducteur (1) qui peut être piloté par un étage d'attaque (20), comprenant :
un détecteur de surtension (11) qui est couplé électriquement avec une sortie du commutateur à semi-conducteur (1), et qui est conçu pour fournir un signal de surtension si une tension électrique à la sortie du commutateur à semi-conducteur (1) dépasse une valeur seuil prédéterminée ;
un élément de limitation (13) qui est conçu pour limiter à une durée prédéterminée le signal de surtension fourni par le détecteur de surtension (11) et pour fournir le signal de surtension limité dans le temps à une borne de sortie de l'élément de limitation (13) ;
un circuit d'activation (12) qui est conçu pour libérer une connexion électrique entre le détecteur de surtension (11) et l'élément de limitation (13) si un signal de pilotage prédéterminé est appliqué à une entrée de l'étage d'attaque (20) pour le commutateur à semi-conducteur (1) ; et
un circuit de compensation (14) qui est couplé électriquement avec la borne de sortie de l'élément de limitation (13) et qui est conçu pour fournir un signal de compensation pour le commutateur à semi-conducteur (1) en fonction du signal de surtension, limité dans le temps par l'élément de limitation (13), à une entrée de l'étage d'attaque (20),
**caractérisé en ce que** le circuit d'activation (12) est conçu pour libérer la connexion électrique entre le détecteur de surtension (11) et l'élément de limitation (13) en fonction d'une comparaison de valeurs de tension entre un signal d'entrée de l'étage d'attaque (20) et un signal de sortie de l'étage d'attaque (20).

2. Dispositif de protection selon la revendication 1, dans lequel le détecteur de surtension (11) comprend une diode à avalanche ou une diode de Zener.

3. Dispositif de protection selon la revendication 1 ou 2, dans lequel l'élément de limitation (13) comprend un filtre passe-haut.

4. Dispositif de protection selon l'une quelconque des revendications 1 à 3, dans lequel l'élément de limitation (13) comprend un couplage R-C.

5. Dispositif de protection selon l'une quelconque des revendications 1 à 4, comprenant une diode qui est disposée entre la borne de sortie du circuit de compensation (14) et la borne de commande du commutateur à semi-conducteur (1).

6. Circuit de pilotage pour un commutateur à semi-conducteur (1), comprenant :
un étage d'attaque (20) doté d'une borne de sortie et d'au moins une borne d'entrée et qui est conçu pour fournir à la borne de sortie un signal de pilotage pour le commutateur à semi-conducteur (1) en fonction d'un signal d'entrée fourni à la borne d'entrée ; et
un dispositif de protection pour le commutateur à semi-conducteur (1) selon l'une quelconque des revendications 1 à 5.

7. Circuit de pilotage selon la revendication 6, dans lequel l'étage d'attaque (20) comprend au moins deux transistors (T1, T2) dont chacun est couplé électriquement par une borne avec la borne de sortie de l'étage d'attaque (20).

8. Procédé de protection d'un commutateur à semi-conducteur (1) qui peut être piloté par un étage d'attaque (20), comprenant les étapes consistant à :
fournir (S1) un signal de surtension par un détecteur de surtension (11) si une tension prédéterminée est dépassée au niveau d'une borne du commutateur à semi-conducteur (1) ;
détecter (S2) un signal de pilotage prédéterminé au niveau d'une entrée de l'étage d'attaque (20) ;
libérer (S3) le signal de surtension par un circuit d'activation (12) qui est conçu pour libérer une connexion électrique entre le détecteur de surtension (11) et un élément de limitation (13) si le signal de pilotage prédéterminé est détecté à une entrée de l'étage d'attaque (20) ;
limiter (S4) le signal de surtension libéré à une durée maximale par l'élément de limitation (13) ;
fournir (S5) un signal de compensation à la borne d'entrée de l'étage d'attaque (20) pour le commutateur à semi-conducteur (1) en fonction du signal de surtension limité dans le temps,
**caractérisé en ce que** le circuit d'activation (12) est conçu pour libérer une connexion électrique entre le détecteur de surtension (11) et l'élément de limitation (13) en fonction d'une comparaison de valeurs de tension entre un signal d'entrée de l'étage d'attaque (20) et un signal de sortie de l'étage d'attaque (20).

9. Procédé selon la revendication 8, dans lequel
l'étape (S3) de libération du signal de surtension libère le signal de surtension si un signal de pilotage pour ouvrir le commutateur à semi-conducteur (1) est appliqué à l'entrée de l'étage d'attaque (20) ; et
l'étape (S5) de fourniture du signal de compensation fournit au niveau de l'entrée de l'étage d'attaque (20) un signal de compensation qui est conçu pour piloter le commutateur à semi-conducteur (1) au moins en partie.
